# EUROPEAN PATENT APPLICATION

(11) **EP 4 456 397 A1**
(43) Date of publication of application: **30.10.2024**
(21) Application number: 23777798.2
(22) Date of filing: 10.03.2023
(51) Int. Cl.: H02M 1/08, H02H 5/04

(54) **POWER DRIVING CIRCUIT AND DRIVING SYSTEM**

(30) Priority: 28.03.2022 CN 202210314262
(71) Applicant: CRM ICBG (WUXI) CO., LTD., Wuxi, Jiangsu 214135 (CN)
(72) Inventor: LIU, Weizhong, Wuxi, Jiangsu 214135 (CN); ZHANG, Chao, Wuxi, Jiangsu 214135 (CN); JIANG, Yaping, Wuxi, Jiangsu 214135 (CN); LI, Jian, Wuxi, Jiangsu 214135 (CN); XIE, Zhiwei, Wuxi, Jiangsu 214135 (CN)
(74) Representative: Canzler & Bergmeier Patentanwälte Partnerschaft mbB
(86) International application number: PCT/CN2023/080884
(87) International publication number: WO 2023/185421

(57) **Abstract**

Provided in the present invention is a power driving circuit. The power driving circuit comprises: a high/low-side driving module, which is used for performing turning-on and turning-off according to a cooperative control signal, and when turning-on is performed, generating a high-side driving signal according to a high-side input signal and generating a low-side driving signal according to a low-side input signal; a cooperative processing module, which is used for comparing an input voltage with a threshold voltage and generating the cooperative control signal, wherein the threshold voltage is switched between a first voltage and a second voltage according to the cooperative control signal; and a temperature sensing module, which is connected to an output end of the cooperative processing module, and is used for sensing a temperature change, generating a sensing signal that changes along with the temperature, generating a sensing increment, and controlling, according to the cooperative control signal, whether to output the sensing increment and the sensing signal in a superposed manner, wherein the input voltage is related to the sensing signal. By means of the power driving circuit provided in the present invention, the problem of inconsistent actions being present between IPMs in an existing driving system is solved.

## Description

### CROSS-REFERENCES TO RELATED APPLICATIONS

The present disclosure claims the benefit of priority to Chinese Patent Application No. CN 202210314262.X, entitled "POWER DRIVING CIRCUIT AND DRIVING SYSTEM", filed with CNIPA on March 28, 2022, the disclosure of which is incorporated herein by reference in its entirety for all purposes.

### FIELD OF THE INVENTION

The present disclosure relates to the field of integrated circuit design, and in particular, to a power driving circuit and a driving system.

### BACKGROUND OF THE INVENTION

Each Intelligent power module (IPM) integrates multiple half-bridge driving circuits, power switching devices, and peripheral sensing circuits into a single package, providing protection features such as overvoltage, overcurrent, and overheat protection. IPMs are characterized by low power consumption, noise immunity, and flexible shutdown capabilities.

Due to their high reliability, ease of use, and the ability to significantly reduce the size of printed circuit boards (PCBs), IPMs are particularly well-suited for driving motors in variable frequency drives and various inverter power supplies. They are an ideal choice for applications such as variable speed control, electric traction, servo drives, and household appliances.

In a driving system composed of a single IPM, temperature sensing is directly achieved by comparing the detected voltage with a threshold voltage. However, in systems with multiple IPMs, there is a consistency issue. Specifically, regarding temperature sensing, even though the multiple IPMs typically use the same detection voltage, differences in threshold voltage and comparator offset voltage among the IPMs can lead to inconsistent comparator behavior, resulting in abnormal system control.

### SUMMARY OF THE INVENTION

In view of the above-mentioned shortcomings, the present disclosure provides a power driving circuit and a driving system, which solve the problem of inconsistent actions among various IPMs in a traditional driving system.

A first aspect of the present disclosure provides a power driving circuit. The power driving circuit comprises a high/low-side driving module, configured to be turned on or off based on a cooperative control signal, and generate a high-side driving signal based on a high-side input signal and generate a low-side driving signal based on a low-side input signal when the high/low-side driving module is turned on; a cooperative processing module, configured to compare an input voltage and a threshold voltage and generate the cooperative control signal, wherein the threshold voltage is switched between a first voltage and a second voltage based on the cooperative control signal; and a temperature sensing module, connected to an output terminal of the cooperative processing module, and configured to sense a temperature variation, generate a sensing signal that changes with temperature, generate a sensing increment, and control whether the sensing increment is superimposedly output with the sensing signal based on the cooperative control signal, wherein the input voltage is associated with the sensing signal.

Optionally, the power driving circuit further comprises a detection module, configured for detecting at least one of voltage, current and temperature, and generate an abnormal signal when an abnormality occurs; a logic processing module, connected to an output terminal of the detection module and configured to generate a protection signal based on the abnormal signal; and a first cooperative-control module, connected between an output terminal of the logic processing module and an input terminal of the cooperative processing module, and configured to pull down the input voltage based on the protection signal.

Optionally, the first cooperative-control module comprises a first MOS transistor. A control terminal of the first MOS transistor is connected to the output terminal of the logic processing module, a first connection terminal of the first MOS transistor is connected to the input terminal of the cooperative processing module, and a second connection terminal of the first MOS transistor is grounded.

Optionally, the cooperative processing module comprises a voltage unit, configured to generate four original voltages that vary monotonically in value, and based on a selection signal, from two of the original voltages with larger values, select one as the first voltage, and from two of the original voltages with smaller values, select one as the second voltage; a comparison unit, connected to an output terminal of the voltage unit, and configured to compare the input voltage with the threshold voltage and generate the cooperative control signal, and select one of the first voltage and the second voltage to be the threshold voltage based on the cooperative control signal.

Optionally, the voltage unit comprises a voltage generator, configured to generate and output the four original voltages; wherein the four original voltages comprises a first original voltage, a second original voltage, a third original voltage, and a fourth original voltage; wherein when the input voltage is negatively correlated with the temperature, values of the first original voltage, the second original voltage, the third original voltage and the fourth original voltage monotonically decreases in sequence; wherein when the input voltage is positively correlated with the temperature, the values of the first original voltage, the second original voltage, the third original voltage and the fourth original voltage monotonically increases in sequence; a first gating switch, wherein a control terminal of the first gating switch receives the selection signal, a first terminal of the first gating switch is connected to the first original voltage, a second terminal of the first gating switch is connected to the second original voltage, and a third terminal of the first gating switch serves as a first output terminal of the voltage unit; and a second gating switch, wherein a control terminal of the second gating switch receives the selection signal, a first terminal of the second gating switch is connected to the fourth original voltage, a second terminal of the second gating switch is connected to the third original voltage, and a third terminal of the second gating switch serves as a second output terminal of the voltage unit.

Optionally, the voltage unit further comprises a first resistor. A first terminal of the first resistor is connected to the control terminals of the first and second gating switches and is configured to receive the selection signal, and a second terminal of the first resistor is grounded.

Optionally, the comparison unit comprises a third gating switch, wherein a control terminal of the third gating switch receives the cooperative control signal, a first terminal of the third gating switch is connected to the first voltage, a second terminal of the third gating switch is connected to the second voltage, and a third terminal of the third gating switch generates the threshold voltage; and a comparator, wherein a first input terminal of the comparator is connected to the third terminal of the third gating switch, a second input terminal of the comparator is connected to the input voltage, and an output terminal of the comparator serves as an output terminal of the comparison unit.

Optionally, the logic processing module is configured to be turned on or off based on a selection signal, and generate the protection signal based on the abnormal signal when the logic processing module is turned on; and/or the power driving circuit further comprises a second cooperative-control module, and the second cooperative-control module is connected to an input terminal of the detection module, and is configured to control whether the detection module receives a detection signal based on the selection signal.

Optionally, the second cooperative-control module comprises a second MOS transistor. A control terminal of the second MOS transistor receives the selection signal, a first connection terminal of the second MOS transistor is connected to the input terminal of the detection module, and a second connection terminal of the second MOS transistor is grounded.

Optionally, the temperature sensing module comprises a temperature sensing unit, configured to sense the temperature variation and generate the sensing signal; an increment generation unit, configured to generate the sensing increment; and a control switch, wherein a control terminal of the control switch is connected to the output terminal of the cooperative processing module, a first terminal of the control switch is connected to an output terminal of the increment generation unit, and a second terminal of the control switch is connected to an output terminal of the temperature sensing unit.

A second aspect of the present disclosure provides a driving system. The driving system comprises at least two power driving circuits, each of which is a power driving circuit according to any of the above embodiments. A selection-signal terminal of a first power driving circuit of the power driving circuits receives a level signal opposite to level signals received by selection-signal terminals of the other power driving circuits of the power driving circuits. A sensing-signal terminal of the first power driving circuit is connected to a power supply voltage through a pull-up resistor or is grounded through a pull-down resistor, and is connected to input voltage terminals of the other power driving circuits. Sensing-signal terminals of the other power driving circuits are floated.

A third aspect of the present disclosure provides another driving system. The driving system comprises at least two power driving circuits, each of which is a power driving circuit according to any of the above embodiments. Selection-signal terminals of the power driving circuits are connected to each other and are connected to a high level signal or a low level signal. Input voltage terminals of the power driving circuits are connected to their respective sensing-signal terminals, and the sensing-signal terminals of the power driving circuits are connected to each other and are connected to a power supply voltage through a pull-up resistor or are grounded through a pull-down resistor.

As described above, the present disclosure relates to the power driving circuit and the driving system. When multiple circuits collaborate, the system utilizes differentiated threshold voltage settings for different circuits and determines whether the sensing increment is superimposedly output with the sensing signal. This approach ensures that when one circuit is triggered, other circuits can also respond promptly, achieving consistent responses across all circuits (i.e., synchronous responses). This design helps prevent unexpected incidents and enhances the reliability of the system during multi-circuit collaboration.

### BRIEF DESCRIPTION OF DRAWINGS

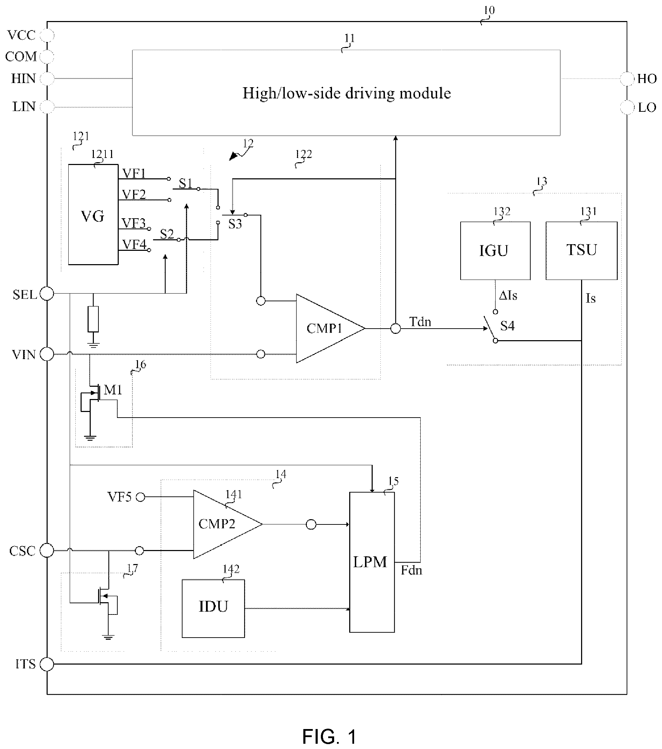

FIG. 1 is a schematic diagram of a power driving circuit according to one embodiment of the present disclosure.

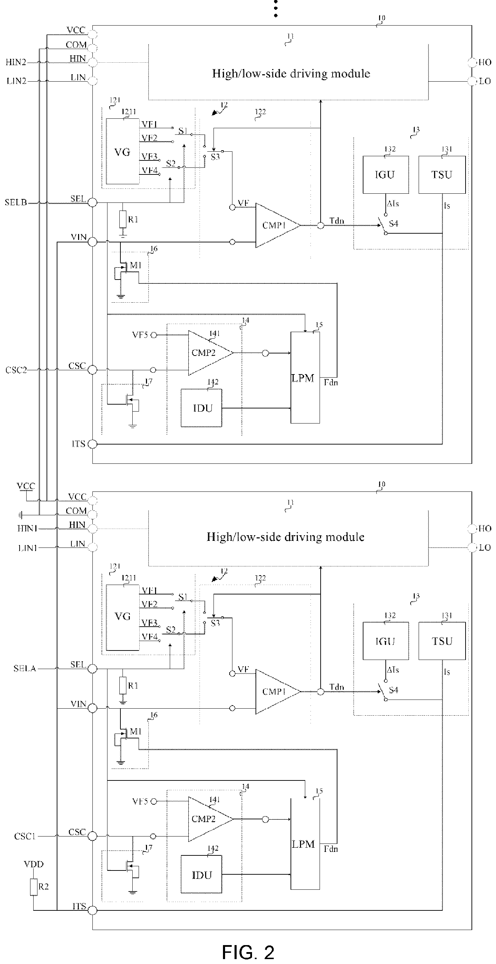

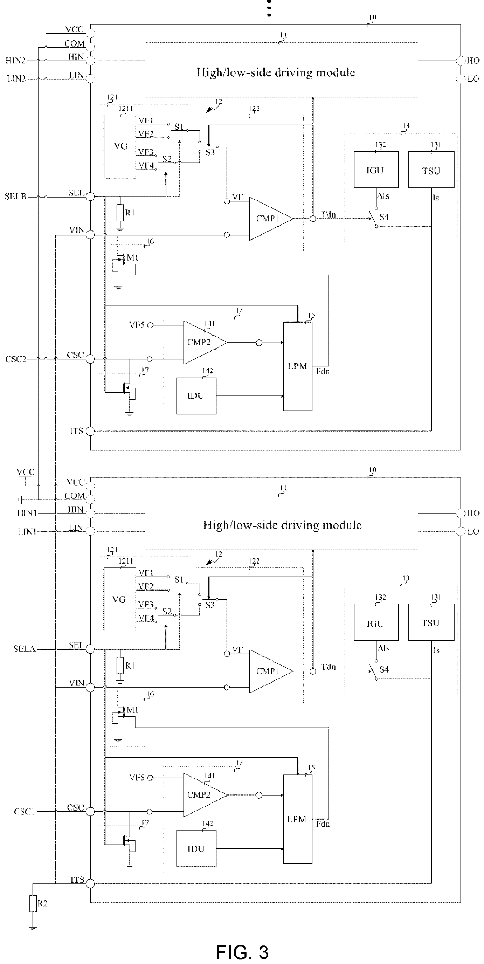

FIG. 2 and FIG. 3 are schematic diagrams of a driving system according to one embodiment of the present disclosure, and FIG. 2 shows that a sensing-signal terminal of a first power driving circuit is connected to a power supply voltage through a pull-up resistor and is connected to input voltage terminals of the other power driving circuits, and FIG. 3 shows that the sensing-signal terminal of the first power driving circuit is grounded through a pull-down resistor and is connected to the input voltage terminals of the other power driving circuits.

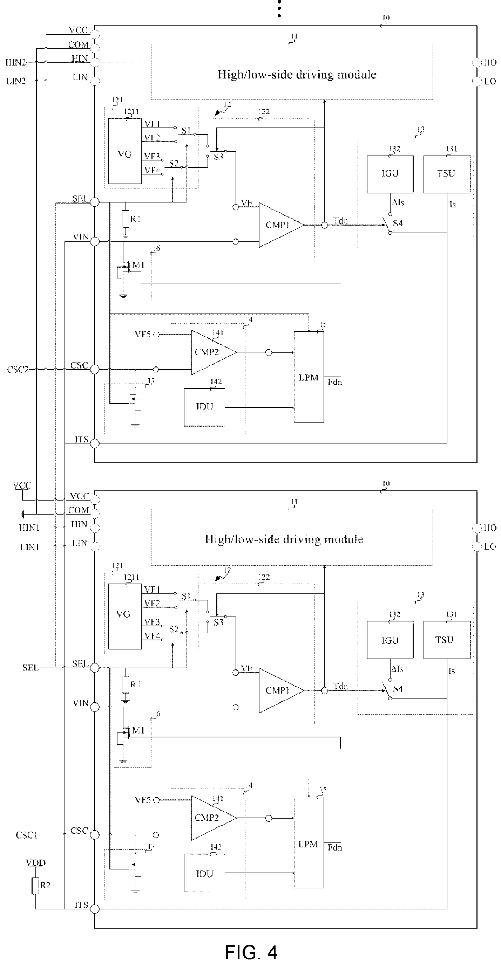

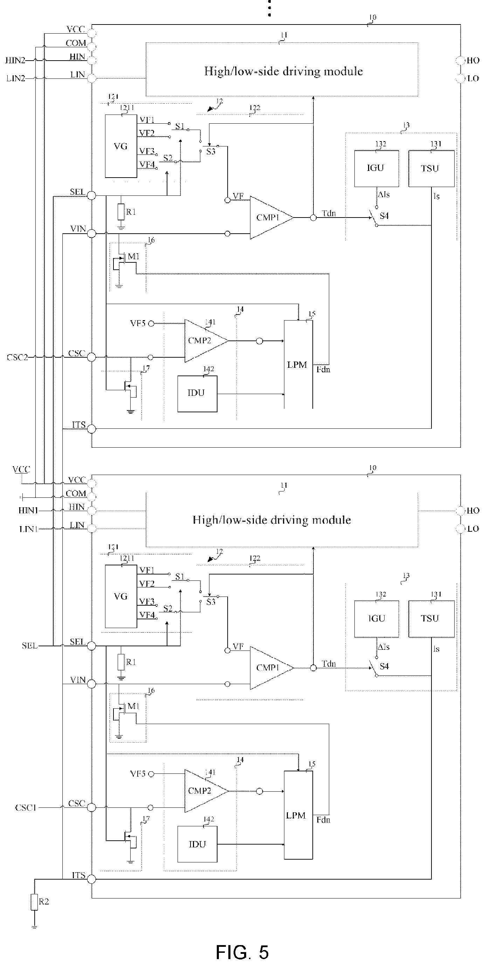

FIG. 4 and FIG. 5 are schematic diagrams of another driving system according to one embodiment of the present disclosure, and FIG. 4 shows that input voltage terminals of the power driving circuits are connected to their respective sensing-signal terminals and the sensing-signal terminals of the power driving circuits are connected to each other and are connected to a power supply voltage through a pull-up resistor, and FIG. 5 shows that the input voltage terminals of the power driving circuits are connected to their respective sensing-signal terminals and the sensing-signal terminals of the power driving circuits are connected to each other and are grounded through a pull-down resistor.

### Reference Numerals

- 10: Power driving circuit
- 11: High/low-side driving module
- 12: Cooperative processing module
- 121: Voltage unit
- 1211: Voltage generation module
- 122: Comparison unit
- 13: Temperature sensing module
- 131: Temperature sensing unit
- 132: Increment generation unit
- 14: Detection module
- 141: Over-current detection unit
- 142: Internal detection unit
- 15: Logic processing module
- 16: First cooperative-control module
- 17: Second cooperative-control module

### DETAILED DESCRIPTION OF THE INVENTION

The embodiments of the present disclosure will be described below. Those skilled can easily understand disclosure advantages and effects of the present disclosure according to contents disclosed by the specification. The present disclosure can also be implemented or applied through other different specific embodiments. Various details in this specification can also be modified or changed based on different viewpoints and applications without departing from the spirit of the present disclosure.

Refer to FIGs. 1-5. It should be noted that the drawings provided in this disclosure only illustrate the basic concept of the present disclosure in a schematic way, so the drawings only show the components closely related to the present disclosure. The drawings are not necessarily drawn according to the number, shape and size of the components in actual implementation; during the actual implementation, the type, quantity and proportion of each component can be changed as needed, and the components' layout may also be more complicated.

### Embodiment 1

As shown in FIG. 1, Embodiment 1 provides a power driving circuit 10, and the power driving circuit 10 comprises a high/low-side driving module 11, a cooperative processing module 12, and a temperature sensing module 13. The power driving circuit 10 further comprises a detection module 14, a logic processing module (or, LPM) 15, and a first cooperative-control module 16. The power driving circuit 10 further comprises a second cooperative-control module 17.

The high/low-side driving module 11 is configured to be turned on or off based on a cooperative control signal Tdn, and when the high/low-side driving module 11 is turned on, the high/low-side driving module 11 is configured to generate a high-side driving signal HO based on a high-side input signal HIN to drive a high-side power transistor, and generate a low-side driving signal LO based on a low-side input signal LIN to drive a low-side power transistor.

Specifically, when the cooperative control signal Tdn is invalid, the high/low-side driving module 11 is turned on. When the cooperative control signal Tdn is valid, the high/low-side driving module 11 is turned off and stops working, so as to achieve the protection function when the circuit is over-temperature.

The cooperative processing module 12 is configured to compare an input voltage VIN and a threshold voltage VF and generate the cooperative control signal Tdn. The threshold voltage VF is switched between a first voltage V1 and a second voltage V2 based on the cooperative control signal Tdn.

Specifically, the cooperative processing module 12 comprises a voltage unit 121 and a comparison unit 122.

The voltage unit 121 is configured to generate four original voltages that vary monotonically in value, and based on a selection signal SEL, from two of the original voltages with larger values, select one as the first voltage V1, and from two of the original voltages with smaller values, select one as the second voltage V2.

More specifically, the voltage unit 121 comprises a voltage generator (or, VG) 1211, a first gating switch S1, and a second gating switch S2. The voltage unit 121 further comprises a first resistor R1.

The voltage generator 1211 is configured to generate and output the four original voltages. The four original voltages comprises a first original voltage VF1, a second original voltage VF2, a third original voltage VF3, and a fourth original voltage VF4. When the input voltage VIN is negatively correlated with the temperature, values of the first original voltage VF1, the second original voltage VF2, the third original voltage VF3 and the fourth original voltage VF4 monotonically decreases in sequence, that is, VF1 >VF2>VF3>VF4. When the input voltage VIN is positively correlated with the temperature, the values of the first original voltage VF1, the second original voltage VF2, the third original voltage VF3 and the fourth original voltage VF4 monotonically increases in sequence, that is, VF1 <VF2<VF3<VF4.

A control terminal of the first gating switch S1 receives the selection signal SEL, a first terminal of the first gating switch S1 is connected to the first original voltage VF1, a second terminal of the first gating switch S1 is connected to the second original voltage VF2, and a third terminal of the first gating switch S1 serves as a first output terminal of the voltage unit 121, to select one of the first original voltage VF1 and the second original voltage VF2 as the first voltage V1 for output.

A control terminal of the second gating switch S2 receives the selection signal SEL, a first terminal of the second gating switch S2 is connected to the fourth original voltage VF4, a second terminal of the second gating switch S2 is connected to the third original voltage VF3, and a third terminal of the second gating switch S2 serves as a second output terminal of the voltage unit 121, to select one of the third original voltage VF3 and the fourth original voltage VF4 as the second voltage V2 for output.

A first terminal of the first resistor R1 is connected to the control terminals of the first and second gating switches S1, S2, and is configured to receive the selection signal SEL, and a second terminal of the first resistor R1 is grounded, so that the control terminals of the first and second gating switches S1, S2 are considered to be grounded when the selection signal SEL is not transmitted to the first terminal of the first resistor R1.

As an example, when the selection signal SEL is configured to be at a low level, each of the first gating switch S1 and the second gating switch S2 connects their respective second terminals with their respective third terminals, that is, the first gating switch S1 selects the second original voltage VF2 as the first voltage V1 for output, and the second gating switch S2 selects the third original voltage VF3 as the second voltage V2 for output. When the selection signal SEL is configured to be at a high level, each of the first gating switch S1 and the second gating switch S2 connects their respective first terminals with their respective third terminals, that is, the first gating switch S1 selects the first original voltage VF1 as the first voltage V1 for output, and the second gating switch S2 selects the fourth original voltage VF4 as the second voltage V2 for output.

Other designs may also be adopted. For example, when the selection signal SEL is configured to be at the low level, the first gating switch S1 selects the first original voltage VF1 as the first voltage V1 for output, and the second gating switch S2 selects the fourth original voltage VF4 as the second voltage V2 for output. When the selection signal SEL is configured to be at the high level, the first gating switch S1 selects the second original voltage VF2 as the first voltage V1 for output, and the second gating switch S2 selects the third original voltage VF3 as the second voltage V2 for output.

The comparison unit 122 is connected to an output terminal of the voltage unit 121, and is configured to compare the input voltage VIN with the threshold voltage VF and generate the cooperative control signal Tdn, and select one of the first voltage V1 and the second voltage V2 to be the threshold voltage VF based on the cooperative control signal Tdn.

More specifically, the comparison unit 122 comprises a third gating switch S3 and a comparator CMP1.

A control terminal of the third gating switch S3 receives the cooperative control signal Tdn, a first terminal of the third gating switch S3 is connected to the third terminal of the first gating switch S1 for connecting the first voltage V1, a second terminal of the third gating switch S3 is connected to the third terminal of the second gating switch S2 for connecting the second voltage V2, and a third terminal of the third gating switch S3 generates the threshold voltage VF.

A first input terminal of the comparator CMP1 is connected to the third terminal of the third gating switch S3 for connecting the threshold voltage VF, a second input terminal of the comparator CMP1 is connected to the input voltage VIN, and an output terminal of the comparator CMP1 serves as an output terminal of the comparison unit 122 for generating the cooperative control signal Tdn.

The cooperative control signal Tdn output by the comparator CMP1 selects one of the first voltage V1 and the second voltage V2 to be the threshold voltage VF through the third gating switch S3, and then the threshold voltage VF is transmitted to the CMP1, thereby forming a hysteresis comparator. The comparator CMP1 is configured to compare the input voltage VIN with the threshold voltage VF, and the output of the comparator CMP1 (i.e., the cooperative control signal Tdn) is inverted when the input voltage VIN equals the threshold voltage VF.

As an example, during an initial phase of circuit operation, when the comparator CMP1 does not output the cooperative control signal Tdn, or when the comparator CMP1 outputs the cooperative control signal Tdn but does not invert the cooperative control signal Tdn, the second terminal and the third terminal of the third gating switch S3 are connected under the control of the cooperative control signal Tdn (e.g., the cooperative control signal Tdn is at a low level, i.e., invalid) to select the second voltage V2 as the threshold voltage VF, at which time, the high/low-side driving module 11 is turned on. When the output of the comparator CMP1 is first inverted, the first terminal and the third terminal of the third gating switch S3 are connected under the control of the inverted cooperative control signal Tdn (e.g., the cooperative control signal Tdn is at a high level, i.e., valid) to select the first voltage V1 as the threshold voltage VF, at which time, the high/low-side driving module 11 is turned off.

Other designs may also be adopted. For example, during the initial phase of circuit operation, when the comparator CMP1 does not output the cooperative control signal Tdn, or when the comparator CMP1 outputs the cooperative control signal Tdn but does not invert the cooperative control signal Tdn, the first terminal and the third terminal of the third gating switch S3 are connected through the cooperative control signal Tdn (where the cooperative control signal Tdn is invalid when its level is low) to select the first voltage V1 as the threshold voltage VF, at which time, the high/low-side driving module 11 is turned on. When the output of the comparator CMP1 is first inverted, the second terminal and the third terminal of the third gating switch S3 are connected under the control of the inverted cooperative control signal Tdn (e.g., the cooperative control signal Tdn is at a high level, i.e., valid) to select the second voltage V2 as the threshold voltage VF, at which time, the high/low-side driving module 11 is turned off.

It should be noted that when the first terminal and the third terminal of the third gating switch S3 are connected, one of the first original voltage VF1 and the second original voltage VF2 is selected as the first voltage V1 based on the output of the first gating switch S1 in the voltage unit 121. Similarly, when the second terminal and the third terminal of the third gating switch S3 are connected, one of the third original voltage VF3 and the fourth original voltage VF4 is selected as the second voltage V2 based on the output of the second gating switch S2 in the voltage unit 121.

The temperature sensing module 13 is connected to an output terminal of the cooperative processing module 12, and is configured to sense a temperature variation, generate a sensing signal ITS that changes with temperature, generate a sensing increment, and control whether the sensing increment is superimposedly output with the sensing signal ITS based on the cooperative control signal Tdn. The input voltage VIN is associated with the sensing signal ITS, and changes with the temperature.

Specifically, the temperature sensing module 13 comprises a temperature sensing unit (or, TSU) 131, an increment generation unit (or, IGU) 132, and a control switch S4.

The temperature sensing unit 131 is configured to sense the temperature variation and generate the sensing signal ITS, such as a current signals Is.

The increment generation unit 132 is configured to generate the sensing increment, such as an increment current ΔIs. In practical applications, the increment generation unit 132 may generate a sensing increment with a fixed value, and may also generate a sensing increment with at least two fixed values and then switch its output.

A control terminal of the control switch S4 is connected to the output terminal of the cooperative processing module 12 to receive the cooperative control signal Tdn, a first terminal of the control switch S4 is connected to an output terminal of the increment generation unit 132 to access the sensing increment, and a second terminal of the control switch S4 is connected to an output terminal of the temperature sensing unit 131.

As an example, when the cooperative control signal Tdn is invalid (i.e., at a low level), the control switch S4 is disconnected under the control of the cooperative control signal Tdn, the sensing increment is not superimposed with the sensing signal ITS, at which time, the temperature sensing module 13 only outputs the sensing signal ITS. When the cooperative control signal Tdn is valid (i.e., at a high level), the control switch S4 is connected under the control of the cooperative control signal Tdn, the sensing increment is superimposed with the sensing signal ITS, at which time, the temperature sensing module 13 outputs a sum of the sensing signal ITS and the sensing increment.

As yet another example, the temperature sensing module 13 may be adjusted according to actual needs. For example, the temperature sensing module 13 may comprises a temperature control unit, a sensing unit, and an increment unit. The temperature control unit is configured to sense the temperature variation and generate a temperature control signal. The sensing unit is connected to an output terminal of the temperature control unit and is configured to generate the sensing signal based on the temperature control signal. The increment unit is connected to the output terminal of the temperature control unit and the output terminal of the cooperative processing module 12, and is configured to generate the sensing increment based on the temperature control signal, and control whether the sensing increment is superimposedly output with the sensing signal based on the cooperative control signal Tdn.

The detection module 14 is configured for detecting at least one of voltage, current and temperature, and generate an abnormal signal when an abnormality occurs.

Specifically, the detection module 14 comprises an over-current detection unit 141 and an internal detection unit (or, IDU) 142.

The over-current detection unit 141 is configured to compare the detection current with a threshold current, and generate a current abnormal signal when the detection current is greater than the threshold current. More specifically, the over-current detection unit 141 is configured as a comparator CMP2. A first input terminal of the comparator CMP2 is connected to the threshold current, a second input terminal of the comparator CMP2 is connected to the detection current, and an output terminal of the comparator CMP2 generates the current abnormal signal.

The internal detection unit 142 is configured to perform an under-voltage detection and/or an over-temperature detection. When the under-voltage detection is performed, the internal detection unit 142 is configured to compare the detection voltage with an under-voltage threshold, and generate a voltage abnormal signal when the detection voltage is less than the under-voltage threshold. When the over-temperature detection is performed, the internal detection unit 142 is configured to compare a detected temperature with a threshold temperature, and generate a temperature abnormal signal when the detected temperature is greater than the threshold temperature. The abnormal signal comprises one or more of the current abnormal signal, the voltage abnormal signal, and the temperature abnormal signal. It should be noted that, when the internal detection unit 142 involves the over-temperature detection, the internal detection unit 142 may form a dual temperature protection mechanism with the temperature sensing module 13 and the cooperative processing module 12.

The logic processing module 15 is connected to an output terminal of the detection module 14 and is configured to generate a protection signal Fdn based on the abnormal signal.

Specifically, the logic processing module 15 is controlled by the selection signal SEL, that is, a control terminal of the logic processing module 15 receives the selection signal SEL, and the logic processing module 15 is configured to be turned on or off based on the selection signal SEL and generate the protection signal Fdn based on the abnormal signal when the logic processing module 15 is turned on.

The first cooperative-control module 16 is connected between an output terminal of the logic processing module 15 and an input terminal of the cooperative processing module 12, and is configured to pull down the input voltage VIN based on the protection signal Fdn, so as to enter a protection state.

Specifically, the first cooperative-control module 16 comprises a first MOS transistor M1. A control terminal of the first MOS transistor M1 is connected to the output terminal of the logic processing module 15 for receiving the protection signal Fdn, a first connection terminal of the first MOS transistor M1 is connected to the input terminal of the cooperative processing module 12, and a second connection terminal of the first MOS transistor M1 is grounded.

The second cooperative-control module 17 is connected to an input terminal of the detection module 14, and is configured to control whether the detection module 14 receives a detection signal based on the selection signal SEL.

Specifically, the second cooperative-control module 17 comprises a second MOS transistor M2. A control terminal of the second MOS transistor M2 receives the selection signal SEL, a first connection terminal of the second MOS transistor M2 is connected to the input terminal of the detection module 14, and a second connection terminal of the second MOS transistor M2 is grounded.

### Embodiment 2

As shown in FIGs. 2 and 3, the present disclosure further provides a driving system. The driving system comprises at least two power driving circuits 10, each of which is a power driving circuit according to any of the power driving circuits in Embodiment 1. A selection-signal (SEL) terminal of a first power driving circuit of the power driving circuits receives a level signal opposite to level signals received by selection-signal terminals of the other power driving circuits of the power driving circuits. A sensing-signal (ITS) terminal of the first power driving circuit is connected to a power supply voltage through a pull-up resistor or is grounded through a pull-down resistor, and is connected to input voltage (VIN) terminals of the other power driving circuits. Sensing-signal terminals of the other power driving circuits are floated.

In practical applications, if the sensing signal is a pull-down current signal, the sensing-signal terminal of the first power driving circuit samples and generates an input voltage by connecting the pull-up resistor with the power supply voltage (as shown in FIG. 2), at which time, if the pull-down current signal is positively correlated with environmental parameters, the input voltage is negatively correlated with the environmental parameters; otherwise, if the pull-down current signal is negatively correlated with the environmental parameters, the input voltage is positively correlated with the environmental parameters.

If the sensing signal is an output current signal, the sensing-signal terminal of the first power driving circuit samples and generates the input voltage by connecting the pull-down resistor with the ground (as shown in FIG. 3), at which time, if the output current signal is positively correlated with the environmental parameters, the input voltage is positively correlated with the environmental parameters; otherwise, if the output current signal is negatively correlated with the environmental parameters, the input voltage is negatively correlated with the environmental parameters.

As an example, since only one power driving circuit in the driving system is sampled to generate the input voltage, whether the pull-up resistor or the pull-down resistor is used for sampling only depends on whether the sensing signal of the sampled power driving circuit is a pull-down current signal or an output current signal, which is independent of the other power driving circuits. Therefore, the sensing signals of the other power driving circuits may be the same as or different from those of the sampled power driving circuit.

It should be noted that the level signal received by the selection-signal terminal of the first power driving circuit is opposite to the level signals received by the selection-signal terminals of the other power driving circuits means: if the selection-signal terminal of the first power driving circuit receives a high level signal, the selection-signal terminals of the other power driving circuits receive a low level signal; and if the selection-signal terminal of the first power driving circuit receives a low level signal, the selection-signal terminals of the other power driving circuits receive a high level signal. The first power driving circuit of the power driving circuits means any power driving circuit in the driving system, while the other power driving circuits of the power driving circuits mean all power driving circuits other than the first power driving circuit.

The cooperative working method of the driving system in Embodiment 2 is further explained, taking as example the case where the number of the power driving circuits is three (not shown in the figures, but FIG. 2 can be used as a reference for understanding), the sensing signal is positively correlated with the temperature, and the input voltage is negatively correlated with the temperature.

### Connections:

In the driving system, three power driving circuits (including a first driving circuit, a second driving circuit, and a third driving circuit) are sequentially arranged from bottom to top. A selection-signal terminal of the first power driving circuit receives the low level signal, so that the second original voltage VF2 serves as the first voltage V1, and the third original voltage VF3 serves as the second voltage V2; Selection-signal terminals of the second power driving circuit and the third power driving circuit receive the high level signal, so that the first original voltage VF1 serves as the first voltage V1, and the fourth original voltage VF4 serves as the second voltage V2; wherein VF1 >VF2>VF3>VF4. A sensing-signal terminal of the first power driving circuit is connected to the power supply voltage VDD through the pull-up resistor R2, and is connected to input voltage terminals of the first power driving circuit, the second power driving circuit and the third power driving circuit. Sensing-signal terminals of the second power driving circuit and the third power driving circuit are floated, so as to obtain the input voltage VIN based on the sensing signal of the first power driving circuit and provide the input voltage VIN to the first power driving circuit, the second power driving circuit and the third power driving circuit.

### Working processes:

When the driving system works normally, in the initial phase of circuit operation, the sensing increment ΔIs in the first power driving circuit is not superimposedly output with the sensing signal, the threshold voltage VF in the first power driving circuit is configured to be the third original voltage VF3, and the threshold voltages VFs in the second power driving circuit and the third power driving circuit are configured to be the fourth original voltage VF4.

The input voltage VIN is negatively correlated with the temperature, and as the temperature increases, the input voltage VIN decreases; when the input voltage VIN decreases to the threshold voltage VF, the output of the comparator CMP1 is inverted.

Since VF3>VF4, when VIN=VDD-Is*R2 decreases to VF3, the output of the comparator CMP1 in the first power driving circuit is first inverted to control the sensing increment Δls to be superimposedly output with the sensing signal, at which time VIN=VDD-Is*R2-ΔIs*R2, so that a falling amplitude of VIN can be rapidly increased by ΔV=Δls*R2.

Make ΔV> (VF3-VF4), such that the input voltage VIN can rapidly decrease from VF3 to below VF4, and the output of the comparator CMP1 in each of the second power driving circuit and the third power driving circuit is inverted. Since this process is completed within a very short time, the first power driving circuit, the second power driving circuit, and the third power driving circuit can be considered as having their outputs inverted simultaneously, so as to control the corresponding high/low-side driving module 11 to be turned off and stop operating, and the temperature starts to decrease.

When the driving system stops working, the sensing increment ΔIs in the first power driving circuit is superimposedly output with the sensing signal, the threshold voltage VF in the first power driving circuit is switched to the second original voltage VF2, and the threshold voltages VFs in the second power driving circuit and the third power driving circuit are switched to the first original voltage VF1.

The input voltage VIN is negatively correlated with the temperature, as the temperature decreases, the input voltage VIN increases, and when the input voltage VIN increases to the threshold voltage VF, the output of the comparator CMP1 is inverted.

Since VF2< VF1, when VIN=VDD-Is*R2-ΔIs*R2 increase to VF2, the output of the comparator CMP1 in the first power driving circuit is first inverted to control the sensing increment Δls in the first power driving circuit to be not superimposedly output with the sensing signal, at which time VIN=VDD-Is*R2, so that the rise amplitude of VIN can be rapidly increased by ΔV'=ΔIs*R2.

Make ΔV'> (VF1-VF2), such that the input voltage VIN can rapidly increase from VF2 to over VF1, and the output of the comparator CMP1 in each of the second power driving circuit and the third power driving circuit is inverted. Since this process is completed within a very short time, the first power driving circuit, the second power driving circuit, and the third power driving circuit can be considered as having their outputs inverted simultaneously, so as to release the abnormality of the system and enter the normal working state.

It should be noted that since the sensing-signal terminals of the second power driving circuit and the third power driving circuit are floated, even if the sensing increments in the second power driving circuit and the third power driving circuit perform corresponding actions under the control of their respective cooperative control signals, the outputs of the second power driving circuit and the third power driving circuit will not be transmitted to other parts of the circuit, thus not affecting the operation of the overall circuit.

### Embodiment 3

As shown in FIGs. 4 and 5, the present disclosure further provides another driving system. The driving system comprises at least two power driving circuits 10, each of which is a power driving circuit according to any of the power driving circuits in Embodiment 1. Selection-signal (SEL) terminals of the power driving circuits are connected to each other and are connected to a high level signal or a low level signal. Input voltage (VIN) terminals of the power driving circuits are connected to their respective sensing-signal (ITS) terminals, and the sensing-signal terminals of the power driving circuits are connected to each other and are connected to a power supply voltage through a pull-up resistor or are grounded through a pull-down resistor.

In practical applications, if the sensing signal is a pull-down current signal, the sensing-signal terminal of each of the power driving circuits samples and generates an input voltage by connecting the pull-up resistor with the power supply voltage (as shown in FIG. 4), at which time, if the pull-down current signal is positively correlated with environmental parameters, the input voltage is negatively correlated with the environmental parameters; otherwise, if the pull-down current signal is negatively correlated with the environmental parameters, the input voltage is positively correlated with the environmental parameters.

If the sensing signal is an output current signal, the sensing-signal terminal of each of the power driving circuits samples and generates the input voltage by connecting the pull-down resistor with the ground (as shown in FIG. 5), at which time, if the output current signal is positively correlated with the environmental parameters, the input voltage is positively correlated with the environmental parameters; otherwise, if the output current signal is negatively correlated with the environmental parameters, the input voltage is negatively correlated with the environmental parameters.

As an example, since each of the power driving circuits in the driving system needs to sample and generate the corresponding input voltage, the sensing signals of the power driving circuits are the same, that is, both are pull-down current signals, or both are output current signals.

It should be noted that the selection-signal terminal of each of the power driving circuits is connected to the high level signal or the low level signal, which determines the threshold voltage of the comparator CMP1 in each of the power driving circuits. Therefore, this setting may be adjusted according to actual needs.

The cooperative working method of the driving system in Embodiment 3 is further explained, taking as example the case where the number of the power driving circuits is three (not shown in the figures, but FIG. 4 can be used as a reference for understanding), the sensing signal is positively correlated with the temperature, and the input voltage is negatively correlated with the temperature.

### Connections:

In the driving system, three power driving circuits (including a first driving circuit, a second driving circuit, and a third driving circuit) are sequentially arranged from bottom to top. Selection-signal terminals of the first power driving circuit, the second power driving circuit and the third power driving circuit are connected to each other and are configured to receive the low level signal, so that the second original voltage VF2 serves as the first voltage V1, and the third original voltage VF3 serves as the second voltage V2, and VF1>VF2>VF3>VF4. Input voltage terminals of the first power driving circuit, the second power driving circuit and the third power driving circuit are connected to their respective sensing-signal terminals. The sensing-signal terminals of the first power driving circuit, the second power driving circuit and the third power driving circuit are connected to each other, and are connected to the power supply voltage VDD through the pull-up resistor.

### Working processes:

When the driving system works normally, in the initial phase of circuit operation, the sensing increment ΔIs in each of the first power driving circuit, the second power driving circuit and the third power driving circuit is not superimposedly output with the sensing signal, and the threshold voltage VF in each of the first power driving circuit, the second power driving circuit and the third power driving circuit is configured to be the third original voltage VF3.

The input voltage VIN is negatively correlated with the temperature, and as the temperature increases, the input voltage VIN of each of the power driving circuits decreases; when the input voltage VIN in the first power driving circuit first decreases to the third original voltage VF3, the output of the comparator CMP1 in the first power driving circuit is first inverted to control the sensing increment Δls in the first power driving circuit to be superimposedly output with the sensing signal. Under the action of the sensing increment Δls in the first power driving circuit, the input voltages VINs of the second power driving circuit and the third power driving circuit can be rapidly decreased by ΔV=Δls*R2.

Make ΔV to be greater than a distribution range of the third original voltage VF3 and cover an offset voltage of the corresponding comparator, such that the input voltages VINs of the second power driving circuit and the third power driving circuit can rapidly decrease below VF3, and the output of the comparator CMP1 in each of the second power driving circuit and the third power driving circuit is inverted. Since this process is completed within a very short time, the first power driving circuit, the second power driving circuit, and the third power driving circuit can be considered as having their outputs inverted simultaneously, so as to control the corresponding high/low-side driving module 11 to be turned off and stop operating, and the temperature starts to decrease.

When the driving system stops working, the sensing increment ΔIs in one of the first power driving circuit, the second power driving circuit and the third power driving circuit is superimposedly output with the sensing signal, and the threshold voltage VF of each of the first power driving circuit, the second power driving circuit and the third power driving circuit is switched to the second original voltage VF2.

The input voltage VIN is negatively correlated with the temperature, and as the temperature decreases, the input voltage VIN of each of the power driving circuits increases; when the input voltage VIN in the first power driving circuit first increases to the second original voltage VF2, the output of the comparator CMP1 in the first power driving circuit is first inverted to control the sensing increment Δls in the first power driving circuit to be not superimposedly output with the sensing signal. Under the action of the sensing increment Δls in the first power driving circuit, the input voltages VINs of the second power driving circuit and the third power driving circuit can be rapidly increased by ΔV'=ΔIs*R2.

Make ΔV' to be greater than a distribution range of the second original voltage VF2 and cover an offset voltage of the corresponding comparator, such that the input voltages VINs of the second power driving circuit and the third power driving circuit can rapidly increase above VF2, and the output of the comparator CMP1 in each of the second power driving circuit and the third power driving circuit is inverted. Since this process is completed within a very short time, the first power driving circuit, the second power driving circuit, and the third power driving circuit can be considered as having their outputs inverted simultaneously, so as to release the abnormality of the system and enter the normal working state.

In summary, for the power driving circuit and the driving system of the present disclosure, when multiple circuits collaborate, the system utilizes differentiated threshold voltage settings for different circuits and determines whether the sensing increment is superimposedly output with the sensing signal. This approach ensures that when one circuit is triggered, other circuits can also respond promptly, achieving consistent responses across all circuits (i.e., synchronous responses). This design helps prevent unexpected incidents and enhances the reliability of the system during multi-circuit collaboration. Therefore, the present disclosure effectively overcomes various shortcomings in the existing technology and has high industrial utilization value.

The above-mentioned embodiments are for exemplarily describing the principle and effects of the present disclosure instead of limiting the present disclosure. Those skilled in the art can make modifications or changes to the above-mentioned embodiments without going against the spirit and the range of the present disclosure. Therefore, all equivalent modifications or changes made by those who have common knowledge in the art without departing from the spirit and technical concept disclosed by the present disclosure shall be still covered by the scope of the present disclosure.

## Claims

1. A power driving circuit, comprising:
a high/low-side driving module, configured to be turned on or off based on a cooperative control signal, and generate a high-side driving signal based on a high-side input signal and generate a low-side driving signal based on a low-side input signal when the high/low-side driving module is turned on;
a cooperative processing module, configured to compare an input voltage and a threshold voltage and generate the cooperative control signal, wherein the threshold voltage is switched between a first voltage and a second voltage based on the cooperative control signal; and
a temperature sensing module, connected to an output terminal of the cooperative processing module, and configured to sense a temperature variation, generate a sensing signal that changes with temperature, generate a sensing increment, and control whether the sensing increment is superimposedly output with the sensing signal based on the cooperative control signal, wherein the input voltage is associated with the sensing signal.

2. The power driving circuit according to claim 1, further comprising:
a detection module, configured for detecting at least one of voltage, current and temperature, and generate an abnormal signal when an abnormality occurs;
a logic processing module, connected to an output terminal of the detection module and configured to generate a protection signal based on the abnormal signal; and
a first cooperative-control module, connected between an output terminal of the logic processing module and an input terminal of the cooperative processing module, and configured to pull down the input voltage based on the protection signal.

3. The power driving circuit according to claim 2, wherein the first cooperative-control module comprises:
a first MOS transistor, wherein a control terminal of the first MOS transistor is connected to the output terminal of the logic processing module, a first connection terminal of the first MOS transistor is connected to the input terminal of the cooperative processing module, and a second connection terminal of the first MOS transistor is grounded.

4. The power driving circuit according to any one of claims 1-3, wherein the cooperative processing module comprises:
a voltage unit, configured to generate four original voltages that vary monotonically in value, and based on a selection signal, from two of the original voltages with larger values, select one as the first voltage, and from two of the original voltages with smaller values, select one as the second voltage;
a comparison unit, connected to an output terminal of the voltage unit, and configured to compare the input voltage with the threshold voltage and generate the cooperative control signal, and select one of the first voltage and the second voltage to be the threshold voltage based on the cooperative control signal.

5. The power driving circuit according to claim 4, wherein the voltage unit comprises:
a voltage generator, configured to generate and output the four original voltages; wherein the four original voltages comprises a first original voltage, a second original voltage, a third original voltage, and a fourth original voltage; wherein when the input voltage is negatively correlated with the temperature, values of the first original voltage, the second original voltage, the third original voltage and the fourth original voltage monotonically decreases in sequence; wherein when the input voltage is positively correlated with the temperature, the values of the first original voltage, the second original voltage, the third original voltage and the fourth original voltage monotonically increases in sequence;
a first gating switch, wherein a control terminal of the first gating switch receives the selection signal, a first terminal of the first gating switch is connected to the first original voltage, a second terminal of the first gating switch is connected to the second original voltage, and a third terminal of the first gating switch serves as a first output terminal of the voltage unit; and
a second gating switch, wherein a control terminal of the second gating switch receives the selection signal, a first terminal of the second gating switch is connected to the fourth original voltage, a second terminal of the second gating switch is connected to the third original voltage, and a third terminal of the second gating switch serves as a second output terminal of the voltage unit.

6. The power driving circuit according to claim 5, wherein the voltage unit further comprises:
a first resistor, wherein a first terminal of the first resistor is connected to the control terminals of the first and second gating switches and is configured to receive the selection signal, and a second terminal of the first resistor is grounded.

7. The power driving circuit according to claim 4, wherein the comparison unit comprises:
a third gating switch, wherein a control terminal of the third gating switch receives the cooperative control signal, a first terminal of the third gating switch is connected to the first voltage, a second terminal of the third gating switch is connected to the second voltage, and a third terminal of the third gating switch generates the threshold voltage; and
a comparator, wherein a first input terminal of the comparator is connected to the third terminal of the third gating switch, a second input terminal of the comparator is connected to the input voltage, and an output terminal of the comparator serves as an output terminal of the comparison unit.

8. The power driving circuit according to claim 2, wherein
the logic processing module is configured to be turned on or off based on a selection signal, and generate the protection signal based on the abnormal signal when the logic processing module is turned on;
and/or
the power driving circuit further comprises a second cooperative-control module, and the second cooperative-control module is connected to an input terminal of the detection module, and is configured to control whether the detection module receives a detection signal based on the selection signal.

9. The power driving circuit according to claim 8, wherein the second cooperative-control module comprises:
a second MOS transistor, wherein a control terminal of the second MOS transistor receives the selection signal, a first connection terminal of the second MOS transistor is connected to the input terminal of the detection module, and a second connection terminal of the second MOS transistor is grounded.

10. The power driving circuit according to any one of claims 1-3, wherein the temperature sensing module comprises:
a temperature sensing unit, configured to sense the temperature variation and generate the sensing signal;
an increment generation unit, configured to generate the sensing increment; and
a control switch, wherein a control terminal of the control switch is connected to the output terminal of the cooperative processing module, a first terminal of the control switch is connected to an output terminal of the increment generation unit, and a second terminal of the control switch is connected to an output terminal of the temperature sensing unit.

11. The power driving circuit according to any one of claims 1-3, wherein the temperature sensing module comprises:
a temperature control unit, configured to sense the temperature variation and generate a temperature control signal;
a sensing unit, connected to an output terminal of the temperature control unit and configured to generate the sensing signal based on the temperature control signal; and
an increment unit, connected to the output terminal of the temperature control unit and the output terminal of the cooperative processing module, and configured to generate the sensing increment based on the temperature control signal, and control whether the sensing increment is superimposedly output with the sensing signal based on the cooperative control signal.

12. The power driving circuit according to claim 2, wherein the detection module comprises:
an over-current detection unit, configured to compare the detection current with a threshold current, and generate a current abnormal signal when the detection current is greater than the threshold current; and
an internal detection unit, configured to perform an under-voltage detection and/or an over-temperature detection, wherein when the under-voltage detection is performed, the internal detection unit is configured to compare the detection voltage with an under-voltage threshold, and generate a voltage abnormal signal when the detection voltage is less than the under-voltage threshold, wherein when the over-temperature detection is performed, the internal detection unit is configured to compare a detected temperature with a threshold temperature, and generate a temperature abnormal signal when the detected temperature is greater than the threshold temperature.

13. A driving system, comprising at least two power driving circuits, each of which is a power driving circuit according to any of claims 1-12, wherein
a selection-signal terminal of a first power driving circuit of the power driving circuits receives a level signal opposite to level signals received by selection-signal terminals of the other power driving circuits of the power driving circuits;
a sensing-signal terminal of the first power driving circuit is connected to a power supply voltage through a pull-up resistor or is grounded through a pull-down resistor, and is connected to input voltage terminals of the other power driving circuits;
sensing signal terminals of the other power driving circuits are floated.

14. A driving system, comprising at least two power driving circuits, each of which is a power driving circuit according to any of claims 1-12, wherein
selection-signal terminals of the power driving circuits are connected to each other and are connected to a high level signal or a low level signal;
input voltage terminals of the power driving circuits are connected to their respective sensing-signal terminals, and the sensing-signal terminals of the power driving circuits are connected to each other and are connected to a power supply voltage through a pull-up resistor or are grounded through a pull-down resistor.
